**Europäisches Patentamt**

**European Patent Office**

**Office européen des brevets**

(19)

(11) Veröffentlichungsnummer: **0 101 077 B1**

(12) **EUROPÄISCHE PATENTSCHRIFT**

(45) Veröffentlichungstag der Patentschrift:
**19.11.87**

(21) Anmeldenummer: **83107963.7**

(22) Anmeldetag: **11.08.83**

(51) Int. Cl.⁴: **H 03 H 9/02, H 03 H 9/64**

(54) **Mit reflektierten akustischen Wellen arbeitendes elektronisches Bauelement.**

(30) Priorität: **17.08.82 DE 3230566**

(43) Veröffentlichungstag der Anmeldung:
**22.02.84 Patentblatt 84/8**

(45) Bekanntmachung des Hinweises auf die Patenterteilung:
**19.11.87 Patentblatt 87/47**

(84) Benannte Vertragsstaaten:
**DE FR GB**

(56) Entgegenhaltungen:
**GB - A - 2 108 800
US - A - 3 772 618
US - A - 3 974 463
US - A - 4 379 274**

**THE TRANSACTIONS OF THE IECE OF JAPAN, Band E60, Nr. 10, Oktober 1977, Seiten 565-566; JUN-ICHIRO MINOWA: "The method of fine frequency adjustment for acoustic surface wave filters"**

(73) Patentinhaber: **Siemens Aktiengesellschaft Berlin und München, Wittelsbacherplatz 2, D-8000 München 2 (DE)**

(72) Erfinder: **Riha, Gerd, Dr., Kameruner Strasse 20, D-8000 München 82 (DE)**
Erfinder: **Veith, Richard, Dipl.-Phys., Habichtstrasse 25, D-8025 Unterhaching (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung bezieht sich auf ein Bauelement wie es im Oberbegriff des Patentanspruches 1 angegeben ist.

In Proc. IEEE Bd. 64 (1976) S. 702 ff., in den US-A-3 883 831 und 3 753 164 sind mit reflektierten akustischen Wellen arbeitende elektronische Bauelemente beschrieben. In der DE-A-3 121 516 ist zur Figur 7 ein mit reflektierten akustischen Wellen arbeitendes Filter beschrieben, das zusätzlich zu einem Eingangswandler zur Anregung einer akustischen Welle in der Oberfläche des vorgesehenen Substratkörpers und einem Ausgangswandler zur Umwandlung der wieder empfangenen akustischen Welle ausserdem zwei Reflektorstrukturen hat, die in jeweils schrägem Winkel ausgerichtete Reflektorfinger besitzen. Die Schrägrichtung der Reflektorfinger der beiden Strukturen ist so gewählt, dass die zunächst vom Eingangswandler in dessen Haupt-Wellenausbreitungsrichtung auf die erste Reflektorstruktur auftreffende akustische Welle in einem im wesentlichen rechten Winkel durch Reflexion so abgelenkt wird, dass die reflektierte Welle mit einer zur anfänglichen Haupt-Wellenausbreitungsrichtung im wesentlichen orthogonalen neuen Haupt-Wellenausbreitungsrichtung weiterläuft. In der zweiten Reflektorstruktur erfolgt eine weitere durch Reflexion bewirkte Umlenkung in eine wieder neue Haupt-Wellenausbreitungsrichtung, mit der die nunmehr zweimal reflektierte akustische Welle in den Ausgangswandler läuft. In diesem Zusammenhang sei darauf hingewiesen, dass bei Vorliegen einer Anisotropie das Material des Substratkörpers – dies trifft zum Beispiel für das häufig verwendete Lithiumniobat zu – 90°-Reflexionen dann auftreten, wenn die Reflektorfinger der reflektierenden Struktur zur Haupt-Wellenausbreitungsrichtung in einem von 45° etwas abweichenden Winkel angeordnet sind. Es ist dies eine Korrekturmassnahme, die dem Fachmann gut bekannt ist und die auch für die nachfolgend noch näher erläuterte vorliegende Erfindung anzuwenden ist, die aber hier desweiteren nicht mehr näher erörtert wird. Es sei im folgenden auch nicht mehr mehr ins Einzelne gehend diskutiert, dass – wie auch die Figur 7 der älteren Anmeldung zeigt – die Reflektorstrukturen nicht vollständig mit Reflektorfingern ausgefüllt sein müssen und/oder die Reflektorfinger gewichtet sind, wie dies zum Beispiel in den weiteren DE-A-3 209 948 und 3 209 962 ebenfalls beschrieben ist. Auch erscheint es hier nicht notwendig, darauf hinzuweisen, dass solche Reflektorstrukturen nicht nur durch auf die Substratoberfläche aufgebrachte Elektrodenstreifen, sondern auch durch in die Substratoberfläche eingebrachte streifenförmige Gräben oder Gruben oder durch in linearer Richtung angebrachte Punktelemente (dots) realisiert sein können, wobei diese dots wiederum punkt- oder fleckweise aufgebrachte Metallisierungen auf der Oberfläche oder Gruben in der Oberfläche sein können.

Aus der DE-B-2 540 012, der US-A-3 772 618 und aus 2334 Trans. IECE Jpn, Bd. E 60. n° 10 (1977. 10), S. 565–566 sind mit akustischen Wellen arbeitende Bauelemente bekannt, die keine Reflektorstruktur besitzen und deren gemeinsame Achse von Eingangswandler und Ausgangswandler schräg zu den Längskanten des Substratkörpers gerichtet ist. Der Substratkörper hat parallele gegenüberliegende Längskanten.

Die schon obengenannte US-A-3 753 164 beschreibt ein Bauelement mit einem im Prinzip rechteckigen Substratkörper mit einzelnen schräg abgetrennten Ecken. Die an diesem Substratkörper somit vorhandenen Kanten sind derart zu den auf dessen Oberfläche vorhandenen Strukturen ausgerichtet, dass dort alle durch Reflexionen möglicherweise auftretenden Störwellen vom Ausgangswandler voll aufgenommen werden. Um dem entgegen zu wirken, hat man dort die eine Längskante des Substratkörpers in üblicher Weise zusätzlich mit Dämpfungsmasse versehen.

Ein weiteres mit reflektierten akustischen Wellen arbeitendes elektronisches Bauelement, bei dem die vorliegende Erfindung ebenfalls anzuwenden ist, ist in der Patentanmeldung DE-A-3 121 516 zur Figur 7 beschrieben.

Im Regelfall ist für mit akustischen Wellen arbeitende elektronische Bauelemente ein piezoelektrischer Substratkörper vorgesehen, der eine im wesentlichen längliche Form hat. Zur Vermeidung von Störungen durch an den Schmalseiten auftretende Reflexionen hat man bereits seit langem dem Substratkörper die Form eines Parallelogramms gegeben, das zueinander parallele Längsseiten-Kanten hat. An den schräggestellten Schmalseiten des Substratkörpers ist häufig ausserdem noch ein als akustischer Sumpf bezeichnetes Material zur Dämpfung akustischer Wellen vorgesehen.

Es ist eine Aufgabe der vorliegenden Erfindung, für ein elektronisches Bauelement nach dem Oberbegriff des Patentanspruches 1 eine (zusätzliche) Massnahme anzugeben, mit der eine weitere Minimierung für das Auftreten von Störsignalen erreicht wird und diese Aufgabe wird für ein solches Bauelement mit den Merkmalen des Kennzeichens des Patentanspruches 1 erfindungsgemäss gelöst. Weitere Ausgestaltungen und Weiterbildungen der Erfindung gehen aus den Unteransprüchen hervor.

Der vorliegenden Erfindung liegt die Erkenntnis zugrunde, dass bei einem Bauelement nach dem Oberbegriff erhebliche Störsignale im Ausgangswandler auftreten, die auf zwei aufeinanderfolgende Reflexionen der angeregten akustischen Welle an den bekanntermassen zueinander parallel ausgerichteten Längskanten des Substratkörpers beruhen. Diese Reflexionen können so stark sein, dass durch weitere Reflexion an der zweiten schräggerichteten Fingerstruktur ein erheblich grosses (zeitverzögertes) (Stör-)Signal im Ausgangswandler auftritt. Die zur Aufgabenlösung vorgesehene erfindungsgemässe Massnahme sieht vor, dass wenigstens die eine lange Längskante des Substratkörpers in einem zu der nach Reflexion der Welle an der ersten Reflektorstruktur vorliegenden Haupt-Wellenausbreitungsrichtung um den Winkel δ von 90° abweichenden Winkel ausgerichtet ist. Vorzugsweise sind die beiden einander gegenüberliegenden langen Längskanten des Substratkörpers in einem von 90° gegenüber dieser Haupt-Wellenausbreitungsrichtung abweichenden Winkel ausgerichtet, wobei die Zählung der beiden Abweichwinkel (und deren Grösse) nicht derart ist, dass diese einander gegenüberstehenden Längskanten des Substratkörpers doch wieder zueinander parallel gerichtet sind. Im Ergebnis verlaufen diese beiden einander gegenüberstehenden langen Längskanten des Substratkörpers keilförmig zueinander, wobei die übrigen kurzen Längskanten in an sich bekannter Weise schräg – aber auch parallel zueinander – ausgerichtet sein können.

Für den bzw. für die für die Erfindung vorgesehenen Abweichwinkel δ bzw. $δ_1$ und $δ_2$, mit denen diese langen Längskanten des Substratkörpers von der bisher üblichen Parallelität zueinander abweichen, ist gemäss einem weiteren Merkmal der Erfindung die Bemessung vorgesehen:

$$δ \text{ bzw. } δ_1 + δ_2 \approx \frac{1}{2} \arcsin \frac{n\,λ}{a}$$

worin a eine Längenabmessung ist, die gleich dem Anteil der Apertur des Ausgangswandlers 5 ist, der durch die störende akustische Welle 112 beschallt wird, λ die der Mittenfrequenz entsprechende Wellenlänge der akustischen Welle in der Oberfläche des Substratkörpers ist, und n eine natürliche Zahl 1, 2, 3 .... ist. Mit der wenigstens angenäherten Einhaltung dieser Winkelbemessung wird nämlich erreicht, dass die auch bei der Erfindung auftretenden zweimaligen Reflexionen der quer im Substratkörper verlaufenden akustischen Welle so beeinflusst werden, dass sie bei einem erfindungsgemässen Bauelement kein Störsignal verursachen.

Die nach solchen zweimaligen Reflexionen an den Längskanten schliesslich in einer wesentlichen der vom Ausgangswandler empfangenen Haupt-Wellenausbreitungsrichtung abweichenden Richtung verlaufende akustische Welle ist wegen des Einflusses des einen oder der mehreren Abweichwinkel δ, $δ_1$ und $δ_2$ von der exakten Haupt-Wellenausbreitungsrichtung des Empfangs um ein solches Mass unterschiedlich, dass diese (abweichend von der Haupt-Wellenausbreitungsrichtung) in den Empfangswandler eintretende akustische Welle dort einen solchen Winkel ihrer Ausbreitungsrichtung hat, der zu Interferenz im Ausgangswandler und damit Signalauslöschung führt.

Der vorangehenden Beschreibung lag – dem besseren Verständnis halber – gedanklich wenigstens weitgehend eine solche Struktur zugrunde, wie sie in der genannten Figur 7 der erwähnten älteren Anmeldung gezeigt ist und die zwei Reflektorstrukturen hat, dass heisst, in der zweimalige Reflexion der akustischen Welle auf ihrem Weg vom Eingangswandler zum Ausgangswandler erfolgt. Die vorliegende Erfindung kann aber auch für eine solche – seltener angewendete – Anordnung verwendet werden, bei der Eingangswandler und Ausgangswandler nicht parallel zueinander ausgerichtet sind, sondern in einem vorzugsweise im wesentlichen rechten Winkel zueinander stehen und nur eine einzige schräggestellte Reflektorstruktur vorgesehen ist, das heisst, nur eine durch Reflexion bewirkte Richtungsänderung der Haupt-Wellenausbreitungsrichtung im Substratkörper erfolgt. Die im Zusammenhang mit der Erfindung relevanten langen Längskanten des Substratkörpers sind dann (wieder) diejenigen Kanten, die im Stand der Technik parallel zur Haupt-Wellenausbreitungsrichtung der vom Eingangswandler ausgehenden zunächst akustischen Welle ausgerichtet sind, und von denen bei der Erfindung wenigstens eine nicht-parallel zur Haupt-Wellenausbreitungsrichtung des Eingangswandlers ausgerichtet ist.

Weitere Erläuterungen der Erfindung gehen aus der nachfolgenden, anhand der Figuren gegebenen Beschreibung hervor.

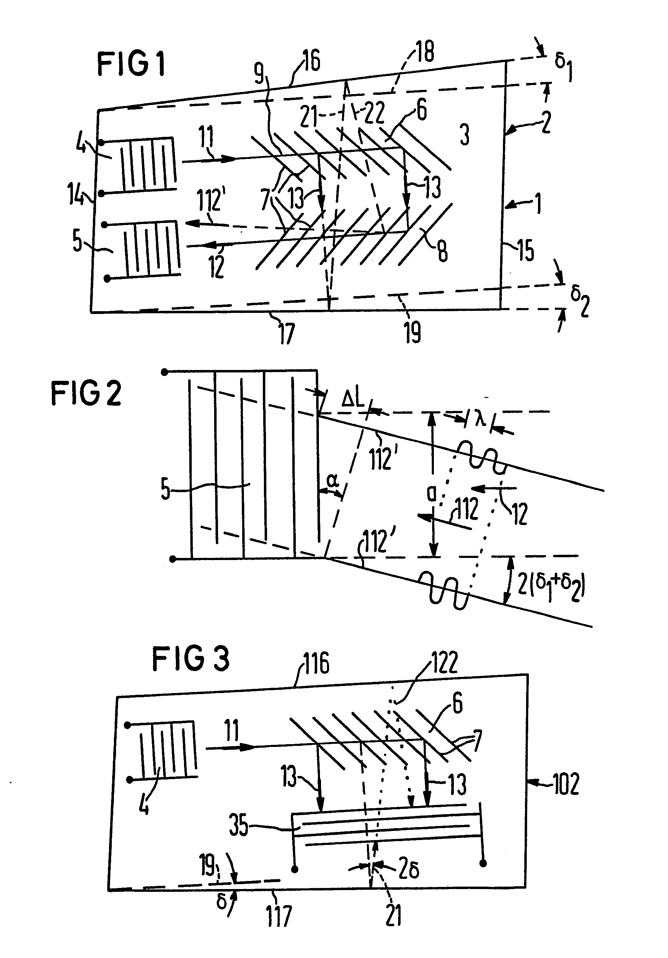

Figur 1 zeigt eine erste Ausführungsform 1 eines erfindungsgemässen elektronischen Bauelementes mit einem perspektivisch dargestellten Substratkörper 2. Dieser Substratkörper 2 ist ein relativ flaches, längliches Plättchen aus beispielsweise Lithiumniobat.

Auf der (in der Figur 1 als Vorderansicht sichtbaren) Oberfläche 3 des Substratkörpers befinden sich ein Eingangswandler 4 und ein Ausgangswandler 5, die in an sich bekannter Weise ausgeführte Interdigitalstrukturen sind. Mit 6 ist eine erste Reflektorstruktur, bestehend aus einer Vielzahl schräggestellter Reflektorfinger 7, bezeichnet. Mit 8 ist eine zweite Reflektorstruktur mit Reflektorfingern 7 bezeichnet. Die Reflektorfinger der beiden Reflektorstrukturen 6 und 8 sind so zueinander ausgerichtet, dass sie auch unter Berücksichtigung einer Anisotropie des Materials des Substratkörpers 2 einen wie mit 9 prinzipiell dargestellten Weg der im Eingangswandler 4 angeregten akustischen Welle hin zum Ausgangswandler 5 bewirken. Mit dem Pfeil 11 ist auf die Haupt-Wellenausbreitungsrichtung der im Eingangswandler erzeugten akustischen Welle hingewiesen. Mit 12 ist auf die Haupt-Wellenausbreitungsrichtung der gewolltermassen im Ausgangswandler 5 zu empfangenden akustischen Welle hingewiesen, und die (zueinander parallelen) Pfeile 13 weisen auf die Haupt-Wellenausbreitungsrichtung hin, die die akustische Welle nach der Reflexion an der ersten Reflektorstruktur 6 und vor der zweiten Reflexion an der weiteren Reflektorstruktur 8 hat. Die schmalen Längskanten 14 und 15 des Substratkörpers 2 sind bei diesem Ausführungsbeispiel in an sich bekannter Weise (zu den Haupt-Wellenausbreitungsrichtungen 11 und 12) schräggestellt angeordnet. Für das Funktionieren der vorliegenden Erfindung können diese Kanten 14 und 15 auch orthogonal zur Haupt-Wellenausbreitungsrichtung 11 bzw. 12 sein. Die beiden längeren, nämlich die (nur) angenähert in Richtung der Hauptwellenausbreitungen 11 und 12 und (nur) etwa orthogonal zu der Haupt- Wellenausbreitungsrichtung 13 verlaufenden Längskanten 16 und 17 des Substratkörpers 2 sind – abweichend vom Stand der Technik – erfindungsgemäss jeweils in einem Winkel $\delta_1$ bzw. $\delta_2$ gegenüber den gestrichelt angedeuteten Linien 18 und 19 ausgerichtet, die zueinander parallele (und zu den Haupt-Wellenausbreitungsrichtungen 11 und 12 parallele) Kanten eines Substratkörpers sein würden. Die Winkel $\delta_1$ und $\delta_2$ brauchen bei der Erfindung nicht gleich gross zu sein und einer dieser Winkel kann auch den Wert Null haben, d.h. es kann eine der Kanten 16 oder 17 mit einer der Kanten 18 bzw. 19 zusammenfallen.

Zu den auf dem Weg 9 zwischen Eingangswandler 4 und Ausgangswandler 5 gewolltermassen verlaufenden akustischen Wellen treten aufgrund nachfolgend näher erörterter Reflexionen noch zusätzlich unerwünschte, störende akustische Wellen hinzu.

Es ist oben bereits darauf hingewiesen worden, dass sich nach der Reflexion an der Reflektorstruktur 6 die gewünschte akustische Welle mit einer der Reflektorstruktur 6 entsprechend breiten Wellenfront in Richtung Haupt-Wellenausbreitungsrichtung 13 ausbreitet. Bei Anordnungen nach dem Stand der Technik ist die mit der Linie 19 lediglich angedeutete Kante des Substratkörpers orthogonal zur Richtung 13. Es wurde nun festgestellt, dass ein sehr beträchtlicher Energieanteil der in Richtung 13 verlaufenden akustischen Welle über die zweite Reflektorstruktur 8 hinaus (bei einer bekannten Anordnung) auf diese Kante 19 trifft und an dieser Kante zur Kante 18 zurückreflektiert wird. Reflexion an der Kante 18 würde bewirken, dass dieser unerwünschte, ebenfalls mit der Richtung 13 laufende Anteil der akustischen Welle nunmehr eine Reflexion an der zweiten Reflektorstruktur 8 erfährt und dann parallel zur Haupt-Wellenausbreitung 12 in den Ausgangswandler 5 gelangen würde, dies jedoch mit einer Zeitverzögerung, die dem quergerichteten Hin- und Herlauf zwischen den Kanten 19 und 18 entspricht. Es sei darauf hingewiesen, dass auch mehrfacher Hin- und Herlauf zwischen den Kanten 18 und 19 aufgetreten sein kann, ehe ein betreffender Wellenanteil (bei einer bekannten Anordnung) in der beschriebenen Weise in den Ausgangswandler gelangt, wie dies für die gewünschte Welle vorgegebenermassen der Fall ist.

Da bei dem dargestellten Ausführungsbeispiel der Erfindung die Kante 17 von der Kante 19 im Winkel $\delta_2$ abweicht, erfolgt die an der Kante 17 auftretende Reflexion des über die zweite Reflektorstruktur 8 hinausgelangten Wellenanteils in einer zur Haupt-Wellenausbreitungsrichtung 13 nicht mehr parallelen (sondern im Winkel $2 \cdot \delta_2$ abweichenden) Richtung des Weges 21 hin zur gegenüberliegenden Kante 16 des Substratkörpers 2. Da (auch) diese andere Längskante 16 des Substratkörpers 2 bei diesem Ausführungsbeispiel nicht-parallel zur Kante 17 ist, verläuft der nach Reflexion an der Kante 16 auftretende Weg 22 der akustischen Welle (ebenfalls) erfindungsgemäss nicht-parallel zur Haupt-Wellenausbreitungsrichtung 13. Die dem Weg 22 folgende akustische Welle trifft auf die zweite Reflektorstruktur 8 in einem solchen von der Haupt-Wellenausbreitungsrichtung 13 abweichenden Winkel auf, dass die an den Fingern 7 der zweiten Reflektorstruktur nunmehr auftretende Reflexion zu einer Haupt-Wellenausbreitungsrichtung 112 dieses Wellenanteils führt, die zur gewollten und vorgegebenen Hauptwellenausbreitungsrichtung 12 einen um das Mass $2(\delta_1 + \delta_2)$ (wenigstens $\delta_1$ oder $\delta_2$ sind verschieden von Null) abweichenden Winkel hat.

Dieser Winkel $2(\delta_1 + \delta_2)$ ist (wie aus der gegenüber Figur 1 wesentlich vergrösserten Darstellung der Figur 2 ersichtlich) so bemessen, dass die mit der Richtung 112 in den Ausgangswandler 5 einfallende störende Welle 112' Auslöschung durch Interferenz in diesem Wandler 5 erfährt. Vollständige Auslöschung der störenden Welle 112' erreicht man hier, wenn der Winkel

$$\alpha = 2(\delta_1 + \delta_2) \text{ mit } \sin \alpha = \frac{\Delta L}{a} = \frac{n \cdot \lambda}{a}$$

bemessen ist. Ist diese Winkelbeziehung nicht exakt eingehalten, so tritt eine entsprechend verminderte Auslöschung der Welle 112' auf. Die Zahl n kann den Wert einer natürlichen Zahl 1, 2, 3 .... haben. Für n = 1 können die Winkelabweichungen $\delta_1$ und/oder $\delta_2$ am geringsten sein, das heisst der erfindungsgemäss keilförmige Substratkörper 2 weicht in seinen Abmessungen am wenigsten von einem bei einem Bauelement vorhandenen Substratkörper mit den Kanten 18 und 19 (und 14 und 15) ab. Für n = 2, 3 .... sind die Winkel $\delta_1$ und/oder $\delta_2$ entsprechend grösser. Dafür brauchen diese Winkel dann nicht so exakt eingehalten zu sein, um dennoch wenigstens weitgehend vollständige Auslöschung gemäss der Erfindung (s. Figur 2) zu erreichen.

Es sei darauf hingewiesen, dass es für die Realisierung der Erfindung genügt, wenn wenigstens die Kante 16 oder wenigstens die Kante 17 von den parallelen Kanten 18 und 19 im Winkel $\delta$ abweicht.

Figur 3 zeigt eine Ausführungsform der Erfindung, bei der der Ausgangswandler 35 (wie aus dieser Figur ersichtlich) quer zum Eingangswandler 4 angeordnet ist und bei der nur eine Reflektorstruktur 6 und damit nur eine Richtungsänderung der Haupt-Wellenausbreitungsrichtung aus der Richtung 11 in die Richtung 13 auftritt. Diese in Richtung 13 gewünschterweise abgelenkte Strahlung tritt in den Ausgangswandler 35 und erzeugt dort das gewünschte elektrische Signal. Es wird jedoch auch ein Anteil dieser Welle in Richtung 13 an der hinter dem Ausgangswandler 35 liegenden Kante 117 des Substratkörpers 102 reflektiert. Da diese Kante 117 zur Orthogonalen der Richtung 13 erfindungsgemäss den Winkel $\delta$ hat, das heisst die Richtung dieser Kante 117 um den Winkel $\delta$ nichtsenkrecht zur Richtung 13 verläuft, läuft die reflektierte Welle 121 mit der Schrägstellung $2\delta$ – nunmehr von rückwärts – in den Ausgangswandler 35 und erfährt dort ihre Auslöschung durch Interferenz. Bei diesem Ausführungsbeispiel muss wenigstens die dem Ausgangswandler 35 benach-

barte Kante den Winkel $\delta$ haben. Die auf dem gepunktet dargestellten Weg 122 verlaufende, an der Längskante 116 reflektierte Strahlung trifft (ebenfalls) abweichend von der Richtung 13 auf den Ausgangswandler 35 (obwohl die Kante 116 bei diesem Ausführungsbeispiel parallel zur Richtung 11 der Welle des Eingangswandlers 4 ist).

### Patentansprüche

1. Mit reflektierten akustischen Wellen arbeitendes elektronisches Bauelement, mit wenigstens einer Reflektorstruktur mit in schrägem Winkel angeordneten Reflektorfingern und mit einer die akustische Welle anregenden Eingangs-Wandlerstruktur sowie mit wenigstens einer Ausgangs-Wandlerstruktur, die sich auf der Oberfläche eines Substratkörpers befindet, gekennzeichnet dadurch, dass die eine oder beide der sich entlang der Haupt-Ausbreitungsrichtung (11) der von der anregenden Eingangs-Wandlerstruktur (4) ausgehenden akustischen Welle erstreckenden Seitenkanten (16, 17; 116, 117) in einem von dieser Richtung (11) abweichenden Winkel ($\delta_1$, $\delta_2$; $\delta$) ausgerichtet sind, wobei gilt

$$\delta \text{ bzw. } (\delta_1 + \delta_2) \approx \frac{1}{2} \arcsin \frac{n \cdot \lambda}{a} \quad ,$$

worin a die Längenabmessung ist, die gleich dem Anteil der Apertur des Ausgangs-Wandlers (5, 35) ist, der durch die störende akustische Welle (112') beschallt wird, $\lambda$ die der Mittenfrequenz entsprechende Wellenlänge der in der Oberfläche (3) des Substratkörpers (2) verlaufenden akustischen Welle und n eine natürliche Zahl ist und die Zählung bei zwei abweichenden Winkeln ($\delta_1$; $\delta_2$) derart ist, dass die sich gegenüberliegenden Längskanten nicht doch wieder zueinander parallel gerichtet sind.

2. Bauelement nach Anspruch 1, gekennzeichnet dadurch, dass n = 1 ist.

3. Bauelement nach Anspruch 1, gekennzeichnet dadurch, dass n eine natürliche Zahl grösser als 1, jedoch kleiner als 10 ist.

4. Bauelement nach einem der Ansprüche 1 bis 3, gekennzeichnet dadurch, dass die beiden Längskanten (16, 17) des Substratkörpers (2) im jeweils einen Winkel ($\delta_1$, $\delta_2$) von der Haupt-Ausbreitungsrichtung (11) der angeregten Welle abweichen (Fig. 1).

5. Bauelement nach einem der Ansprüche 1, 2 oder 3, gekennzeichnet dadurch, dass bei einer Anordnung des Eingangs-Wandlers (4) und des Ausgangs-Wandlers (35) mit von der Parallelität abweichendem Winkel zueinander (Fig. 3) wenigstens die der Rückseite des Ausgangs-Wandlers (35) benachbart liegende Längskante (117) des Substratkörpers (102) in Winkel $\delta$ gegenüber der Wellenfront der in dem Ausgangs-Wandler (35) vorgegebenerweise (13) einfallenden Welle ausgerichtet ist.

### Claims

1. An electronic component operating with reflected acoustic waves, comprising at least one reflector structure with reflector fingers arranged at an oblique angle, an input transducer structure which generates the acoustic wave and at least one output transducer structure arranged on the surface of a substrate body, characterised in that one or both of the longitudinal edges (16, 17; 116, 117) which extend along the main propagation direction (11) of the acoustic wave emanating from the generating input transducer structure (4) are aligned at an angle ($\delta_1$, $\delta_2$; $\delta$) which differs from this direction (11), where:–

$$\delta \text{ or } (\delta_1 + \delta_2) \text{ as the case may be } \approx \frac{1}{2} \text{ arc sin } \frac{n \cdot \lambda}{a}$$

where a is the length measurement equal to that part of the aperture of the output transducer (5, 35) acoustically irradiated by a disturbing acoustic wave component (112'), $\lambda$ is the wavelength corresponding to the mean frequency of the acoustic wave passing over the surface (3) of the substrate body (2), n is a natural number, and in the case of two differing angles ($\delta_1$; $\delta_2$) the counting is such that the oppositely-arranged longitudinal edges do not again become parallel.

2. A component as claimed in Claim 1, characterised in that n = 1.

3. A component as claimed in Claim 1, characterised in that n is a natural number greater than 1 but lower than 10.

4. A component as claimed in one of Claims 1 to 3, characterised in that the two longitudinal edges (16, 17) of the substrate body (2) each differ by a respective angle ($\delta_1$, $\delta_2$) from the main propagation direction (11) of the excited wave (Fig. 1).

5. A component as claimed in one of Claims 1, 2 or 3, characterised in that with a non-parallel arrangement having the input transducer (4) and the output transducer (35) arranged at an angle to one another (Fig. 3), at least that longitudinal edge (117) of the substrate body (102) adjacent the rear of the output transducer (35) is aligned at an angle $\delta$ relative to the given (13) wave front of the wave entering the output transducer (35).

### Revendications

1. Composant électronique opérant avec des ondes acoustiques réfléchies, avec au moins une structure de réflecteurs à doigts-réflecteurs disposés suivant un angle oblique, et avec une structure de transducteur d'entrée excitant les ondes acoustiques ainsi qu'avec au moins une structure de transducteur de sortie située sur la surface d'un corps de substrat, caractérisé par le fait que l'une ou les deux arêtes latérales (16, 17; 116, 117) qui s'étendent le long de la direction principale de propagation (11) des ondes acoustiques de la structure de transducteur d'excitation d'entrée, sont orientées suivant un angle ($\delta_1$, $\delta_2$; $\delta$) qui s'écarte de cette direction, avec la relation

$$\delta \text{ ou } (\delta_1 + \delta_2) \approx \frac{1}{2} \arcsin \frac{n \cdot \lambda}{a},$$

où a est la longueur qui est égale à la partie de l'ouverture du transducteur de sortie (5, 35) qui reçoit l'onde acoustique (112′) de perturbation, $\lambda$ est la longueur d'onde, qui correspond à la fréquence centrale, de l'onde acoustique qui se propage dans la surface (3) du corps de substrat, et n est un nombre naturel, alors que le comptage pour deux angles ($\delta_1$; $\delta_2$) différents entre eux, est tel que les arêtes latérales opposées sont quand même et à nouveau parallèles entre elles.

2. Composant selon la revendication 1, caractérisé par le fait que n = 1.

3. Composant selon la revendication 1, caractérisé par le fait que n est un nombre naturel supérieur à 1, mais inférieur à 10.

4. Composant selon l'une des revendications 1 à 3, caractérisé par le fait que les deux arêtes longitudinales (16, 16) du corps de substrat (2) s'écartent respectivement suivant un angle ($\delta_1$, $\delta_2$) de la direction principale de propagation (11) de l'onde excitée (figure 1).

5. Composant selon l'une des revendications 1, 2 ou 3, caractérisé par le fait que dans un agencement du transducteur d'entrée (4) et du transducteur de sortie (35) entre eux et suivant des angles qui s'écartent du parallélisme (figure 3), au moins l'arête longitudinale (117) du corps de substrat (102) qui est voisine de la face postérieure du transducteur de sortie (35), fait un angle $\delta$ avec le front des ondes de l'onde incidente de façon prédéterminée sur le transducteur de sortie (35).

FIG 1

FIG 2

FIG 3